# FASCICULE DE BREVET EUROPEEN

(11) **EP 3 001 447 B1**
(45) Date de publication et mention de la délivrance du brevet: **02.10.2019**
(21) Numéro de dépôt: 15184344.8
(22) Date de dépôt: 08.09.2015
(51) Int. Cl.: H01L 21/265, H01L 21/324, H01L 29/20

(54) **PROCÉDÉ D'ACTIVATION DE DOPANTS DANS UNE COUCHE SEMI-CONDUCTRICE À BASE DE GAN PAR IMPLANTATIONS ET TRAITEMENTS THERMIQUES SUCCESSIFS**
VERFAHREN ZUR AKTIVIERUNG VON DOTIERMITTELN IN EINER HALBLEITERSCHICHT AUF GAN-BASIS DURCH IMPLANTATION, UND DARAUF FOLGENDE WÄRMEBEHANDLUNGEN
METHOD FOR ACTIVATING DOPANTS IN A GAN SEMICONDUCTOR LAYER BY CONSECUTIVE IMPLANTATIONS AND HEAT TREATMENTS

(30) Priorité: 26.09.2014 FR 1459131
(43) Date de publication de la demande: 30.03.2016
(73) Titulaire: Commissariat à l'Energie Atomique et aux Energies Alternatives, 75015 Paris (FR)
(72) Inventeur: Agraffeil, Claire, 38000 Grenoble (FR)
(74) Mandataire: Talbot, Alexandre

(56) Documents cités:
- WO-A1-82/01619
- US-A1- 2012 068 188
- S. M. C. MIRANDA ET AL: "Sequential multiple-step europium ion implantation and annealing of GaN", PHYSICA STATUS SOLIDI (C), vol. 11, no. 2, 20 janvier 2014 (2014-01-20), pages 253-257, XP055184498, ISSN: 1862-6351, DOI: 10.1002/pssc.201300210
- LORENZ K ET AL: "High-temperature annealing and optical activation of Eu-implanted GaN", APPLIED PHYSICS LETTERS, AMERICAN INSTITUTE OF PHYSICS, US, vol. 85, no. 14, 1 janvier 2004 (2004-01-01), pages 2712-2714, XP012062749, ISSN: 0003-6951, DOI: 10.1063/1.1801686
- "Thermal annealing characteristics of Si and Mg-implanted GaN thin films", APPLIED PHYSICS LETTERS, AMERICAN INSTITUTE OF PHYSICS, US, vol. 68, no. 19, 6 mai 1996 (1996-05-06), pages 2702-2704, XP012015207, ISSN: 0003-6951, DOI: 10.1063/1.116314
- NOGALES E ET AL: "Failure mechanism of AlN nanocaps used to protect rare earth-implanted GaN during high temperature annealing", APPLIED PHYSICS LETTERS, AMERICAN INSTITUTE OF PHYSICS, US, vol. 88, no. 3, 17 janvier 2006 (2006-01-17), pages 31902-031902, XP012082402, ISSN: 0003-6951, DOI: 10.1063/1.2162797

## Description

### Domaine technique de l'invention

L'invention est relative à un procédé d'activation de dopants dans une couche semi-conductrice.

### État de la technique

L'implantation ionique est couramment utilisée pour doper des semiconducteurs. Dans le cas d'un dopage de type n (excès d'électrons), réalisé par exemple par l'implantation d'ions Si⁺ dans une couche de GaN, le taux d'activation obtenu avec les procédés actuels est quasiment de 100%.

En revanche, pour réaliser un dopage de type p (excès de trous) dans un semi-conducteur tel que du GaN, les méthodes connues ne permettent pas d'obtenir d'aussi bons résultats, en particulier lorsque les impuretés dopantes sont des atomes de Mg ou un mélange de P et de Mg.

L'une des raisons pour lesquelles le taux d'activation est moins bon, est que les rayons atomiques du magnésium et du gallium sont très différents (1,36 Å pour l'un contre 1,26 Å pour l'autre). Les atomes de magnésium se placent donc difficilement en position substitutionnelle au cours de la mise en oeuvre du procédé de dopage. Ceci entraîne une difficulté particulière pour activer ce type de dopants : la dose implantée doit être importante, et le traitement thermique d'activation doit être réalisé à une température élevée pendant une durée longue.

Il s'avère également que le GaN non dopé présente un dopage résiduel conséquent de type n. A cela s'ajoute une contamination en atomes de H, O ou Si due au procédé d'épitaxie et/ ou des éventuelles étapes de procédés ultérieures. Au final, la concentration en dopants de type n est en général de l'ordre de 10¹³ à 10¹⁸ atomes/cm². Il faut donc utiliser une dose élevée en espèces dopantes de type p pour compenser le dopage n et obtenir un matériau dopé p. Cependant la dose implantée ne peut généralement pas dépasser 5.10¹⁵ atomes/cm², sinon le semi-conducteur devient complètement amorphe.

Après une implantation ionique, pour restaurer la qualité cristalline du semi-conducteur et activer les dopants, un traitement thermique est classiquement réalisé. Dans le cas où les dopants ont été introduits par épitaxie en phase vapeur aux organométalliques (« metalorganic vapor phase epitaxy » ou MOCVD en anglais), un recuit d'activation peut également être utilisé.

Une première méthode peut consister à réaliser un traitement thermique standard (« furnace annealing » en anglais). Si la température du traitement thermique est inférieure à 850°C, les dopants peuvent diffuser dans le semi-conducteur et la dégradation de ce dernier par évaporation est limitée. Toutefois, le taux d'activation des dopants reste très faible car la température de traitement thermique est trop basse, et/ou la durée d'un traitement thermique applicable industriellement est trop courte.

Un traitement thermique à une température supérieur à 850°C entraîne une dégradation du semi-conducteur à base de GaN. Aussi, il est nécessaire de déposer une couche de protection pour éviter la dégradation du semi-conducteur. Généralement, les couches de protection utilisées sont à base d'AlN, de SiO₂, ou de Si₃N₄. Un traitement thermique standard FA ou un traitement thermique rapide (« rapide thermal annealing » ou RTA, et « Rapid Thermal Processing » ou RTP en anglais) peut alors être réalisé. La température appliquée lors du traitement thermique peut être comprise entre 1000 et 1300°C si la qualité de la couche de protection est suffisante et que le substrat sur lequel le GaN est déposé est à base de silicium. Si le semi-conducteur est déposé sur un bloc de sapphire, le traitement thermique peut être réalisé sur une plage de température s'étendant jusqu'à 1600°C.

Il est également possible de combiner un traitement thermique avec l'application d'une pression élevée pouvant aller jusqu'à 15 kbar, et d'une atmosphère contrôlée, par exemple à base d'azote. Dans ce cas, le dépôt d'une couche de protection n'est pas nécessaire. Ce procédé d'activation de dopants est décrit dans la publication « Annealing of GaN under high pressure of nitrogen » (S. Porowski et al. 2002, Journal of Physics : Condensed Matter, Vol 14).

Le document US2012/068188 A1 divulgue une procédé d'activation de dopants dans un semi-conducteur à base de GaN.

Ces méthodes sont des alternatives pour contourner l'instabilité de la couche de GaN à des températures supérieures à 850°C, mais ne présentent pas de résultats beaucoup plus probants ou sont beaucoup plus coûteux en raison de la spécificité des équipements employés.

La surface de GaN est donc généralement recouverte par une couche de protection. La nature, la qualité, l'épaisseur de cette couche va définir un « budget thermique » d'activation, c'est-à-dire la température pouvant être appliquée pendant le traitement thermique, ainsi que la durée de ce dernier. Des solutions ont permis d'augmenter ce budget thermique pour augmenter le taux d'activation des dopants. Cependant, le fait d'appliquer un traitement thermique à haute température pendant une certaine durée entraîne d'autres problèmes tels que la diffusion en profondeur des impuretés dopantes, ce qui entraîne une perte de dose et une déformation du profil de concentration des dopants implantés. Un autre inconvénient est la contamination de la couche de GaN par des espèces dopantes de type n (Si, O, C) ou contaminantes (H).

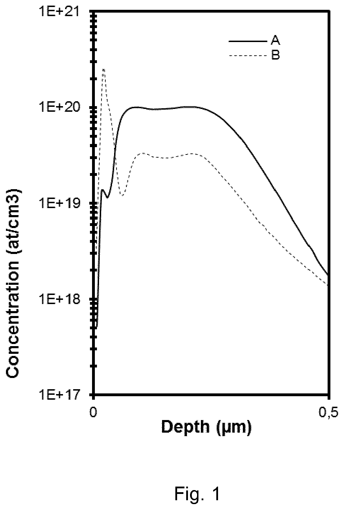

Les courbes de la figure 1 montrent des analyses SIMS représentant la concentration en impuretés dopantes Mg implantées dans un semi-conducteur à base de GaN déposé sur un substrat de silicium. L'implantation est réalisée par faisceau d'ions ayant une énergie de 200keV. Les deux courbes présentent les profils de concentration dans le GaN avant (courbe A) et après (courbe B) un traitement thermique standard FA à 1100°C. Avant traitement thermique (courbe A), la concentration en Mg est maximale à une profondeur comprise entre 0,1 et 0,3 µm, puis diminue fortement pour des profondeurs plus grandes. Après traitement thermique à 1100°C (courbe B), on observe un pic de concentration en Mg en surface du semi-conducteur, puis une forte diminution de concentration, un plateau de concentration pour une profondeur comprise entre 0,15 et 0,25 µm, puis une diminution pour des profondeurs plus importantes. Le profil de concentration en dopants est fortement inhomogène, et la perte de dose est importante. Elle est divisée de moitié par rapport à la dose initiale au cours du traitement thermique.

### Objet de l'invention

Un objet de l'invention consiste à mettre en oeuvre un procédé d'activation de dopants de type n ou p dans un semi-conducteur à base de GaN qui soit efficace et peu couteux afin de pouvoir être mis en oeuvre dans un cadre industriel.

A cet effet, le procédé comporte les étapes suivantes :
- prévoir un substrat comprenant une couche en matériau semi-conducteur à base de GaN
- réaliser au moins deux fois les étapes successives suivantes :
   ∘ implanter des impuretés dopantes électriques dans la couche en matériau semi-conducteur,
   ∘ réaliser un traitement thermique de manière à activer les impuretés dopantes électriques dans la couche en matériau semi-conducteur, une couche de protection recouvrant la couche en matériau semi-conducteur lors du traitement thermique,
deux étapes d'implantation d'impuretés dopantes électriques étant séparées par une étape de traitement thermique, et l'une au moins des étapes de traitement thermique est réalisée par recuit atmosphérique à une température comprise entre 1100°C et 1300°C pendant une durée de 1 à 7 heures.

Selon un mode de mise en oeuvre, la couche de protection peut être retirée après au moins l'un des traitements thermiques, puis à nouveau déposée sur la couche en matériau semi-conducteur avant le traitement thermique suivant. Dans ce cas, la couche de protection peut être comprise entre 5 et 500 nm, avantageusement entre 5 et 100 nm, et préférentiellement entre 5 et 40 nm.

En alternative, la couche de protection est utilisée pour plusieurs traitements thermiques successifs, et son épaisseur peut être comprise entre 5 et 500 nm, avantageusement entre 5 et 150 nm, et préférentiellement entre 80 et 120nm.

Le matériau de la couche de protection peut être choisi parmi SiO₂, Si₃N₄, AlN.

Par ailleurs, lors de chaque étape d'implantation, une dose intermédiaire supérieure à 10% de la dose totale à implanter peut être implantée dans la couche en matériau semi-conducteur, et les impuretés dopantes électriques peuvent être implantées à une profondeur différente de celle obtenue lors des étapes d'implantation précédentes.

Selon un mode de mise en oeuvre, l'une au moins des étapes de traitement thermique peut également être réalisée sous atmosphère contrôlée à une pression inférieure à 15 kbar, à une température comprise entre 1000°C et 1600°C pendant une durée de 1 à 20 minutes. L'une au moins des étapes de traitement thermique peut aussi être une combinaison d'au moins deux recuits de durées et de températures différentes.

Dans le cas d'un dopage de type p, les impuretés dopantes électriques peuvent être choisies parmi Mg, P, N, Ca, Zn ou C. Si le dopage souhaité est de type n, les impuretés dopantes électriques peuvent être choisies parmi Si, Be, Ge, ou O.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1, présentée dans l'état de la technique, présente un profil de d'implantation de dopants de type Mg⁺ dans un semi-conducteur à base de GaN avant et après traitement thermique standard à 1100°C,
- les figures 2 et 7 illustrent de façon schématique un mode de mise en oeuvre du procédé de dopage,
- la figure 8 présente le profil d'implantation de dopants de type Mg dans un semi-conducteur à base de GaN après mise en oeuvre d'un procédé de l'art antérieur, et après la mise en oeuvre du présent procédé pour différentes températures de traitement thermiques.

### Description détaillée

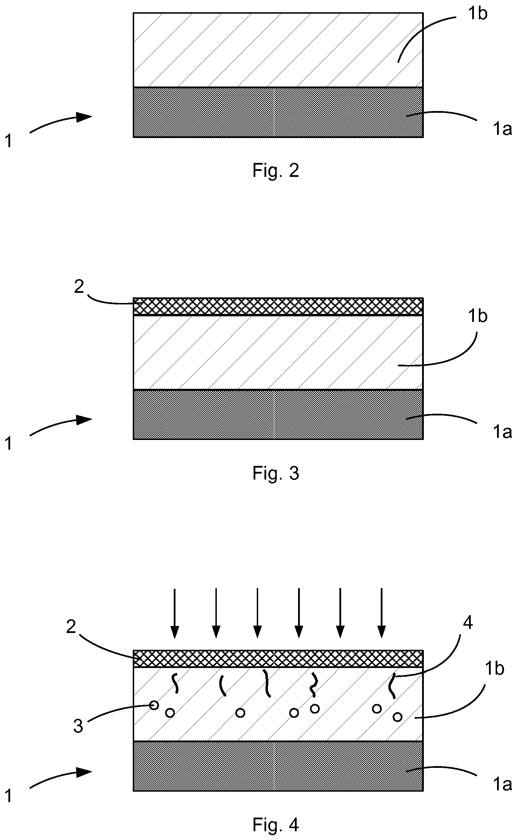

Le procédé d'activation de dopants est mis en oeuvre à partir d'un substrat 1 comportant avantageusement un support 1a par exemple en silicium, en sapphire, Al₂O₃, ou SiC. et une couche en matériau semi-conducteur 1b à base de GaN (cf. figure 2). En alternative, le substrat 1 peut être en GaN massif.

Lorsque le substrat 1 est un bloc de GaN massif, il est possible de recouvrir la face arrière de couches de protection avantageusement identiques à celles déposées sur le substrat 1 en face avant, et qui vont être décrites ci-après. La face avant du substrat 1 est définie ici comme la face impactée par le faisceau d'impuretés dopantes, et la face arrière comme la face opposée à la face avant.

La réalisation du substrat 1 peut comprendre une première étape de nettoyage du support 1a, comme par exemple un nettoyage de type RCA si le support 1a est en silicium.

La couche en matériau semi-conducteur 1b peut ensuite être fabriquée suivant un mode de réalisation particulier par croissance épitaxiale directement sur le support 1a. Le matériau du support 1a doit être judicieusement choisi pour avoir des paramètres de maille similaires à ceux de la couche en matériau semi-conducteur 1b afin que cette dernière croisse de manière cohérente. Pour améliorer la qualité de la couche en matériau semi-conducteur 1b, une couche intermédiaire à base d'AlGaN d'au moins 1 *µ*m d'épaisseur peut éventuellement être déposée sur le support 1a avant la croissance épitaxiale de la couche 1b (mode de réalisation non représenté). Par exemple, pour un support 1a en saphhire, la couche en matériau semi-conducteur 1b à base de GaN peut être directement déposée sur le support 1a si celui-ci est réalisé en sapphire. En revanche, s'il est réalisé en silicium, il est judicieux de déposer une couche tampon à base d'AlGaN.

Par matériau à base de AlGaN, il faut comprendre un matériau comprenant entre 0 et 50% atomique de Ga et au moins 50% atomique cumulé pour les atomes de Al et N. Le matériau de type AlGaN peut donc être du AlN.

Lorsque la réalisation de la couche en matériau semi-conducteur 1b est terminée, celle-ci peut avantageusement avoir une épaisseur comprise entre 5 nm et 10 µm, préférentiellement entre 500 nm et 1,5 µm, et idéalement égale à 1 µm.

Suivant un autre mode de réalisation alternatif, la couche en matériau semi-conducteur 1b peut être réalisée sur un support silicium (1a) par une technique de transfert comme par exemple le smart-cut avec création d'une zone de fragilisation par implantation ionique.

A ce stade, il peut être envisagé de réaliser une première étape d'implantation ou d'implanter des espèces dopantes directement par épitaxie lors du dépôt de la couche en matériau semi-conducteur 1b (modes de mise en oeuvre non représentés sur les figures).

Lorsque la couche en matériau semi-conducteur est destinée à être dopée n, des dopants de type Si peuvent être implantés dans la couche 1b. De manière alternative, il est envisageable d'implanter d'autres espèces (ions ou neutres) telles que Be, Ge, O à la place des impuretés de type Si.

Pour réaliser un dopage de type p, des impuretés dopantes électriques 3 telles que des espèces (ions ou neutres) Mg seuls ou co-implantés avec des espèces (ions ou neutres) P ou N peuvent être implantées dans la couche en matériau semi-conducteur 1b. Une autre option peut être d'implanter des espèces dopantes (ions ou neutres) Ca, Zn ou C.

Le substrat 1 est destiné à subir au moins deux fois des étapes d'implantation d'impuretés dopantes et de traitement thermique à température élevée, comme on le verra plus loin. La quantité de dopants implantés est décomposée en plusieurs étapes successives d'implantation. Deux étapes d'implantations sont séparées par une étape de recuit. De cette manière, l'étape de recuit va au moins partiellement guérir les défauts générés par l'implantation précédente.

Au-delà d'une température de l'ordre de 850°C, la couche en matériau semi-conducteur 1b à base de GaN est fortement dégradée lors du recuit. Une couche de protection 2 est donc avantageusement déposée afin de réaliser le traitement thermique du substrat 1 à une température élevée tout en limitant fortement la dégradation de la surface de la couche semi-conductrice 1b (cf. figure 3).

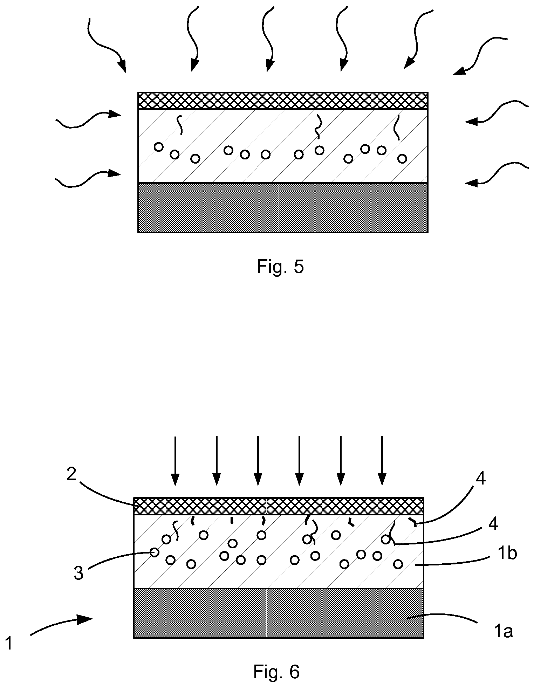

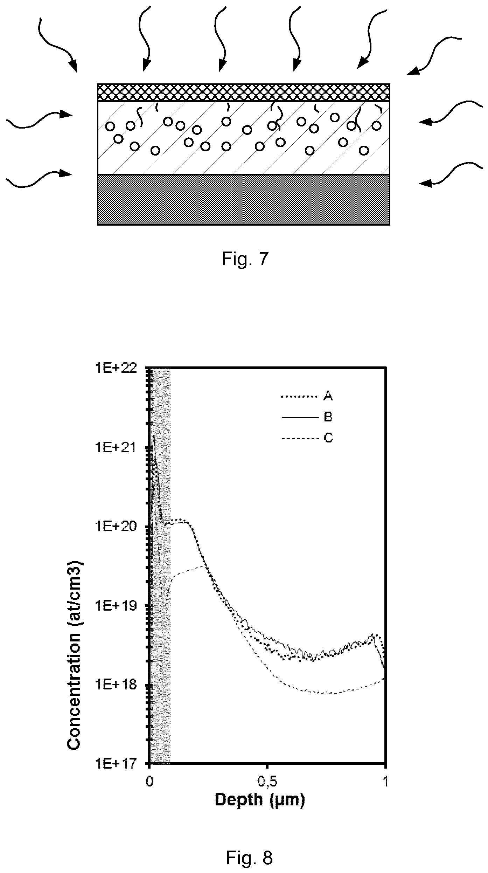

Selon un premier mode de mise en oeuvre, le procédé peut comprendre une étape de formation d'une couche de protection 2 (cf. figure 3) réalisée avant ou après une première étape d'implantation (cf. figure 4) dans la couche en matériau semi-conducteur 1b, et avant une première étape de traitement thermique d'activation des impuretés dopantes (cf. figure 5). Les nouvelles étapes d'implantation (cf. figure 6) et de traitement thermique (cf. figure 7) sont ensuite réalisées de manière successive.

Pour que la couche de protection 2 forme une barrière de protection compacte lors des traitements thermiques successifs, son épaisseur peut être comprise entre 5 et 500 nm, avantageusement entre 5 et 150 nm, et préférentiellement entre 80 et 120nm. La perte de dose des espèces dopantes est limitée, et le taux d'activation des impuretés dopantes est amélioré par rapport aux dispositifs de l'art antérieur.

Selon un mode de mise en oeuvre alternatif, le procédé peut comprendre successivement une étape de dépôt d'une couche de protection 2, une étape d'implantation, une étape de traitement thermique destiné à activer les dopants, et une étape de retrait de la couche de protection 2. Ces étapes sont ensuite répétées pour réaliser une nouvelle implantation.

Le fait d'utiliser la couche de protection 2 permet d'une part de limiter la perte de dose des espèces dopantes, et d'autre part d'augmenter le budget thermique d'activation subit par la couche semi-conductrice 1b. Des traitements thermiques réalisés à plus haute température et donc sur une durée plus courte sont envisageables, ce qui permet de mettre en oeuvre le procédé en un temps plus court. Le taux d'activation des impuretés dopantes 3 est également amélioré.

Selon un autre mode de mise en oeuvre, les étapes de formation de la couche de protection 2 et d'implantation peuvent être interverties par rapport au mode de mise en oeuvre qui vient d'être décrit. Le procédé peut donc comporter successivement une étape d'implantation, une étape de formation d'une couche de protection 2, une étape de traitement thermique, et une étape de retrait de la couche de protection 2. Ces étapes sont ensuite répétées pour implanter à nouveau la couche en matériau semi-conducteur 1b.

Comme pour le mode de mise en oeuvre précédent, le fait de déposer une nouvelle couche de protection 2 avant chaque étape de traitement thermique permet d'augmenter le budget thermique subit par la couche semi-conductrice et donc le taux d'activation des dopants dans la couche en matériau semi-conducteur 1b sans risque de dégradation.

Lorsque la couche de protection 2 est éliminée après un traitement thermique, la surface de la couche en matériau semi-conducteur peut éventuellement être nettoyée. Un mode opératoire possible peut être de réaliser un nettoyage par désoxydation à base d'un mélange NH₄OH/H₂O (1 :1) à 60°C. De manière alternative, le nettoyage de la première couche de protection peut être réalisé par toute autre chimie de préparation de surface adaptée au matériau.

Lorsque la couche de protection 2 est retirée à l'issue de chaque traitement thermique, la couche de protection n'a pas besoin d'être aussi épaisse que dans un mode de mise en oeuvre où elle est conservée pendant tout le processus d'activation des dopants 3. Pour obtenir des résultats équivalents à ceux du premier mode de mise en oeuvre, chaque couche de protection 2 déposée peut avoir une épaisseur comprise entre 5 et 500 nm, avantageusement entre 5 et 100 nm, et préférentiellement entre 5 et 40 nm.

Les trois modes de mise en oeuvre qui viennent d'être décrits peuvent être combinés. Par exemple, une première couche de protection 2 peut être déposée avant la première étape d'implantation, et une deuxième couche de protection peut être déposée après la deuxième implantation. La deuxième couche de protection peut ensuite être conservée jusqu'à la fin du procédé d'activation de dopants.

Afin de réaliser une couche semi-conductrice 1b dopée n, la couche de protection 2 peut avantageusement être à base de silicium. Le matériau peut alors être du SiO₂ ou du Si₃N₄. La couche de protection 2 peut également être réalisée en silicium amorphe même si ce mode de réalisation est moins avantageux. Ainsi, lors du traitement thermique, des atomes de Si peuvent diffuser en direction de la couche en matériau semi-conducteur 1b pour renforcer le dopage de type n.

La couche de protection 2 à base silicium peut être réalisée par un dépôt chimique en phase vapeur à basse pression (« Low Pressure Chemical Vapor Déposition » ou « LPCVD » en anglais) ou PECVD à une température comprise entre 150 et 800°C, avantageusement entre 700 et 800°C.

Lorsque le procédé est mis en oeuvre pour réaliser un semi-conducteur dopé p, le matériau de la couche de protection 2 peut avantageusement être en AlN. La couche de protection permet alors d'empêcher la contamination de la couche semi-conductrice 1b par des molécules de silicium ou d'oxygène, et forme une barrière efficace pour empêcher l'évaporation des molécules d'azote de la couche en matériau semi-conducteur 1b lors du traitement thermique.

La couche de protection 2 en AlN peut par exemple être déposée par MOCVD dans un équipement identique à celui ayant servi pour la croissance épitaxiale de la couche en matériau semi-conducteur 1b. Le dépôt peut être réalisé à la température de nucléation du matériau semi-conducteur ou à une température inférieure. De manière alternative, le dépôt de la couche de protection peut être réalisé par Dépôt Physique en phase Vapeur (« Physical Vapor Déposition » ou PVD en anglais).

Le dépôt d'une couche de protection 2 en AlN le peut également être envisagé pour un dopage de type n de la couche en matériau semi-conducteur 1b. Pour le dopage n, la couche d'AlN peut être déposée directement sur la couche 1b, ou après le dépôt de la couche à base de silicium.

En alternative, il est également possible de réaliser des dépôts successifs d'AlN, de Mg ou MgO, puis à nouveau d'AlN pour former la couche de protection 2 sur la couche en matériau semi-conducteur 1b.

Pour obtenir un dopage de bonne qualité dans l'ensemble de la couche en matériau semi-conducteur 1b, 3 à 5 implantations successives apparaissent suffisantes. Au delà de 5 implantations, le coût de mise en oeuvre du procédé devient très élevé par rapport à l'amélioration du dopage de la couche semi-conductrice et semble réservé à des applications technologiques très spécifiques.

Un procédé dopage comportant 3 ou 4 implantations successives permet d'obtenir un dopage de qualité à un coût raisonnable, et peut donc être mis en oeuvre à l'échelle industrielle.

De manière préférée, la dose totale Dₜ implantée dans la couche en matériau semi-conducteur 1b peut être comprise entre 10¹⁵ et 10¹⁶ atomes/cm², et la dose intermédiaire Dᵢ implantée lors de chaque étape d'implantation est supérieure à 10% de la dose totale Dₜ. Avantageusement, la dose intermédiaire Dᵢ est comprise entre 25 et 40% de la dose totale Dₜ implantée.

A chaque étape d'implantation, la profondeur d'implantation Z, c'est-à-dire la profondeur à laquelle se trouve le pic de concentration en impuretés dopantes 3 dans le matériau semi-conducteur 1b, peut avantageusement être différente afin d'avoir une répartition plus homogène des impuretés dopantes 3. Le procédé comportant aux moins deux étapes d'implantation, l'implantation des impuretés dopantes 3 est réalisée à au moins deux profondeurs d'implantation Z différentes.

Selon un mode de mise en oeuvre, les impuretés dopantes électriques 3 peuvent être implantées de plus en plus profondément à chaque nouvelle étape d'implantation (mode de mise en oeuvre non représenté).

A l'inverse, les impuretés dopantes électriques 3 peuvent être implantées successivement de moins en moins profondément dans la couche en matériau semi-conducteur 1b. Pour cela, une méthode consiste à diminuer l'énergie d'implantation à chaque nouvelle étape d'implantation. Ce mode de mise en oeuvre particulièrement avantageux est illustré sur les figures 4 à 7.

Dans le procédé illustré sur les figures, une première dose d'impuretés dopantes 3 correspondant à une dose intermédiaire Dᵢ de la dose totale est implantée dans la couche en matériau semi-conducteur 1b (cf. figure 4).

L'implantation des impuretés dopantes 3 crée des défauts structuraux 4 dans la matrice semi-conductrice comme des joints de grain ou des lacunes. Ces défauts 4 limitent fortement la qualité électrique du semi-conducteur et doivent être réparés, au moins en partie.

Pour réparer les dommages 4 causés à la couche en matériau semi-conducteur 1b, et pour activer les dopants 3, un traitement thermique est effectué (cf. figure 5).

Dans le traitement thermique selon l'invention, l'une au moins des étapes de traitement thermique est réalisée par recuit atmosphérique à une température comprise entre 1100°C et 1300°C pendant une durée de 1 à 7 heures.

Après traitement thermique, les dopants 3 activés sont plus nombreux dans la zone implantée, et les défauts structuraux 4 sont moins nombreux.

Le traitement thermique permet de restaurer la qualité de la maille cristalline de la couche en matériau semi-conducteur 1b, et de rétablir son état de surface. Les propriétés mécaniques et structurelles du semi-conducteur sont alors analogues à celle d'un semi-conducteur n'ayant pas subi d'implantation d'impuretés dopantes.

Le fait d'implanter les impuretés dopantes 3 de manière successive, et de réaliser un traitement thermique à l'issu de chaque étape d'implantation permet d'obtenir un procédé plus efficace car la dose d'impuretés dopantes 3 activées est plus élevée. Le procédé de dopage est également moins invasif car le traitement thermique permet de reconstruire la maille cristalline du semi-conducteur 1b.

Une deuxième implantation ionique peut ensuite être réalisée, avantageusement avec une énergie différente et avantageusement inférieure à la dose Dᵢ utilisée pour la première implantation. Dans l'exemple illustré à la figure 6, les dopants 3 sont implantés moins profondément dans la couche en matériau semi-conducteur 1b lors de la deuxième implantation. Comme dans la première étape d'implantation, les dopants implantés ont généré des défauts 4 dans la matrice semi-conductrice.

Cette deuxième implantation est donc suivie d'un deuxième traitement thermique (cf. figure 7) destiné d'une part à restaurer la qualité cristalline du matériau semi-conducteur 1b, et d'autre part à activer les impuretés dopantes 3, de manière à garantir une bonne qualité électrique pour le matériau semi-conducteur 1b.

Ces deux répétitions d'étapes d'implantation et de traitement thermique peuvent être suivies d'autres étapes d'implantation et de traitement thermique non représentées sur les figures.

Un exemple de mise en oeuvre du procédé concerne une couche semi-conductrice 1b de 1 µm de GaN déposée sur un substrat de silicium 1a. Une couche de protection 2 de 100 nm de SiO₂ est alors déposée sur la couche semi-conductrice 1b afin de protéger cette dernière. Le dépôt de la couche de protection 2 peut avantageusement être réalisé par LPCVD à une température comprise entre 700 et 800°C.

On réalise ensuite un dopage de type p à température ambiante à l'aide d'ions Mg⁺, la dose totale à implanter étant de 3.10¹⁵ atomes/cm². Dans une première étape d'implantation ionique, les 2/3 de la dose totale sont implantés à une énergie égale à 200 keV.

Un traitement thermique standard est ensuite réalisé pendant une durée de 4 à 6h sur le substrat placé à une température de 1100°C. Le traitement thermique permet d'activer les impuretés dopantes 3 dans la zone d'implantation et de réparer partiellement les défauts 4 créés dans le semi-conducteur 1b lors de l'étape d'implantation.

Une deuxième implantation ionique est ensuite effectuée pour implanter 1/6 de la dose totale souhaitée, soit 0,5.10¹⁵ atomes/cm². Les impuretés dopantes 3 sont implantées avec une énergie de 100 keV, de sorte à être positionnées dans une zone plus proche de la surface de la couche semi-conductrice 1b.

Un deuxième traitement thermique analogue au premier est ensuite réalisé, de manière à réparer les défauts 4 créés par la deuxième implantation et à activer les impuretés dopantes 3.

Enfin, une troisième implantation est mise en oeuvre pour implanter les 1/6 restants de la dose totale souhaitée, soit 0,5.10¹⁵ atomes/cm². Les impuretés dopantes 3 sont avantageusement implantées à une énergie moindre, par exemple de 50 keV pour être positionnées plus près de la surface du semi-conducteur 1b. Un troisième traitement thermique similaire aux deux premiers est ensuite réalisé afin d'activer les dopants 3 implantés lors de la troisième étape d'implantation. Cela permet également de restaurer une partie des défauts créés dans la matrice semi-conductrice 1b.

Les courbes de la figure 8 présentent les profils d'implantation obtenus à partir d'un procédé de dopage p d'une couche de GaN selon l'exemple qui vient d'être décrit. La courbe A est obtenue pour un substrat ayant subit des traitements thermiques standards à 1100°C pendant 6h, tandis que la courbe B est obtenue pour un substrat ayant subi des traitements thermiques standards à 1200°C pendant 10 min. A titre de comparaison, la courbe C correspond au profil d'implantation d'un substrat selon le procédé de l'art antérieur décrit précédemment (cf. figure 1).

Il apparaît clairement sur la figure 8 que la réalisation d'implantations et de traitements thermiques successifs améliore l'homogénéité de la concentration en dopants dans la matrice semi-conductrice.

Par ailleurs, les profils de concentration obtenus sont semblables malgré les différences dans la mise en oeuvre des traitements thermiques : 1100°C - 6h pour la courbe A, et 1200°C - 10min pour la courbe B. Il est donc possible d'utiliser ces températures de traitements thermiques indifféremment.

Il faut également noter que l'utilisation d'une couche de protection en SiO₂ n'est pas préjudiciable à la qualité du dopage p dans la couche en matériau semi-conducteur 1b. Cela est pourtant contre-intuitif car une couche de protection réalisée en SiO₂ libère des atomes de Si lors des traitements thermiques, et donc contribue au dopage de type n de la matrice.

Comme pour le substrat dopé selon le procédé de l'art antérieur, une certaine quantité d'impuretés dopantes 3 migre vers la surface de la couche semi-conductrice 1b. Toutefois, le puits de concentration disparaît avec le procédé mis en oeuvre, et le plateau de concentration présent avant les traitements thermiques reste présent après les traitements thermiques. La perte de dose de l'espèce dopante implantée par faisceau d'ions est deux fois plus faible lorsque le procédé décrit ci-dessus est mis en oeuvre.

En alternative à l'exemple qui vient d'être décrit, il est possible de réaliser les recuits sous une atmosphère contenant de l'azote et à haute pression (inférieure à 15 kbar).

Tout en gardant une atmosphère contrôlée et une haute pression, le traitement thermique peut être effectué à une température plus élevée pendant une durée plus courte, par exemple pendant 1 à 20 min à 1200°C, ou pendant 1 à 10 min à 1300°C.

Si la couche en matériau semi-conducteur 1b est déposée sur un support de sapphire 1a au lieu d'un support de silicium, il est alors possible de réaliser des traitements thermiques à une température pouvant atteindre 1600°C.

Il est enfin possible de réaliser des traitements thermiques de type RTA/RTP sous atmosphère contrôlée en azote plutôt que des traitements thermiques standards, ou de les combiner entre eux après chaque étape d'implantation d'impuretés dopantes. Les gammes de températures utilisées pour les recuits RTA/RTP sont analogues à celles utilisées pour les recuits standards.

Il est également possible de modifier les conditions d'implantation en modifiant la température d'implantation des impuretés dopantes. Celle-ci peut être comprise entre 15 et 700°C, et préférentiellement égale à 500°C. Le fait de se placer dans cette gamme de température permet d'éviter d'entrer dans des plages de températures où la surface du GaN se dégrade et où l'on observe un dégagement d'azote, ces phénomènes étant d'autant plus probables que la couche en matériau semi-conducteur 1b subit un bombardement ionique. Ainsi, cette gamme de température permet d'une part de faciliter l'insertion des impuretés dopantes 3 dans la matrice pendant l'implantation, et d'autre part de faciliter la réorganisation de la matrice sous forme d'un réseau cristallin.

Au lieu de diminuer de manière monotone l'énergie d'implantation à chaque nouvelle étape d'implantation ionique, il est possible de l'augmenter de manière monotone pour implanter les impuretés dopantes 3 de plus en plus profondément.

Le procédé de dopage d'un semi-conducteur à base de GaN permet d'obtenir un taux d'activation d'impuretés dopantes n ou p particulièrement élevé, et présente une répartition plus homogène des impuretés dopantes dans la matrice par rapport aux procédés de l'art antérieur.

La formation de structures en GaN dopé n ou p est particulièrement utile à la réalisation de transistors à haute mobilité électronique, diode Schottky et de composants optoélectroniques tels que les LED.

## Revendications

1. Procédé d'activation de dopants de type n ou p dans un semi-conducteur à base de GaN comportant les étapes suivantes :
• prévoir un substrat (1) comprenant une couche en matériau semi-conducteur (1b) à base de GaN,
• réaliser au moins deux fois les étapes successives suivantes :
∘ implanter des impuretés dopantes électriques (3) dans la couche en matériau semi-conducteur (1b),
∘ réaliser un traitement thermique de manière à activer les impuretés dopantes électriques (3) dans la couche en matériau semi-conducteur (1b), une couche de protection (2) recouvrant la couche en matériau semi-conducteur (1b) lors du traitement thermique,
deux étapes d'implantation d'impuretés dopantes électriques (3) étant séparées par une étape de traitement thermique, et
l'une au moins des étapes de traitement thermique étant réalisée à pression atmosphérique à une température comprise entre 1100°C et 1300°C pendant une durée de 1 à 7 heures.

2. Procédé d'activation de dopants selon la revendication 1, dans lequel la couche de protection (2) est retirée après au moins l'un des traitements thermiques, puis une deuxième couche de protection (2) est déposée sur la couche en matériau semi-conducteur (1b) avant le traitement thermique suivant.

3. Procédé d'activation de dopants selon l'une des revendications 1 et 2, dans lequel l'épaisseur de la couche de protection (2) et/ou de la deuxième couche de protection (2) est comprise entre 5 et 500 nm, avantageusement entre 5 et 100 nm, et préférentiellement entre 5 et 40 nm.

4. Procédé d'activation de dopants selon l'une des revendications 1 et 2, dans lequel la couche de protection (2) et/ou la deuxième couche de protection (2) est utilisée pour plusieurs traitements thermiques successifs, et dans lequel son épaisseur est comprise entre 5 et 500 nm, avantageusement entre 5 et 150 nm, et préférentiellement entre 80 et 120nm.

5. Procédé d'activation de dopants selon l'une quelconque des revendications 1 à 4, dans lequel le matériau de la couche de protection (2) et/ou de la deuxième couche de protection (2) est choisi parmi SiO₂, Si₃N₄ ou AlN.

6. Procédé d'activation de dopants selon l'une quelconque des revendications 1 à 5, dans lequel à chaque étape d'implantation, une dose intermédiaire supérieure à 10% de la dose totale à implanter est implantée.

7. Procédé d'activation de dopants selon l'une quelconque des revendications 1 à 6, dans lequel l'une au moins des étapes d'implantation est réalisée à une température comprise entre 15 et 700°C, préférentiellement égale à 500°C.

8. Procédé d'activation de dopants selon l'une quelconque des revendications 1 à 7, dans lequel, à chaque nouvelle étape d'implantation, les impuretés dopantes électriques (3) sont implantées à une profondeur différente de celle obtenue lors des étapes d'implantation précédentes.

9. Procédé d'activation de dopants selon l'une quelconque des revendications 1 à 8, dans lequel l'une au moins des étapes de traitement thermique est réalisée sous atmosphère contrôlée à une pression inférieure à 15 kbar, à une température comprise entre 1000°C et 1600°C pendant une durée de 1 à 20 minutes.

10. Procédé d'activation de dopants selon l'une quelconque des revendications 1 à 9, dans lequel l'une au moins des étapes de traitement thermique est une combinaison d'au moins deux recuits de durées et de températures différentes.

11. Procédé d'activation de dopants selon l'une quelconque des revendications 1 à 10, dans lequel les impuretés dopantes électriques (3) sont choisies parmi Mg, P, N, Ca, Zn ou C pour former un dopage de type p.

12. Procédé d'activation de dopants selon l'une quelconque des revendications 1 à 10, dans lequel les impuretés dopantes électriques (3) sont choisies parmi Si, Be, Ge, ou O pour former un dopage un type n.

## Patentansprüche

1. Verfahren zur Aktivierung von Dotierungsmitteln des Typs n oder p in einem Halbleiter auf Basis von GaN, umfassend die folgenden Schritte:
• Vorsehen eines Substrats (1), umfassend eine Schicht aus Halbleitermaterial (1b) auf Basis von GaN,
• mindestens zweimaliges Durchführen der folgenden aufeinanderfolgenden Schritte:
∘ Implantieren von elektrisch dotierenden Verunreinigungen (3) in die Schicht aus Halbleitermaterial (1b),
∘ Durchführen einer Wärmebehandlung, um die elektrisch dotierenden Verunreinigungen (3) in der Schicht aus Halbleitermaterial (1b) zu aktivieren, wobei eine Schutzschicht (2) die Schicht aus Halbleitermaterial (1b) bei der Wärmebehandlung bedeckt,
wobei zwei Schritte des Implantierens von elektrisch dotierenden Verunreinigungen (3) durch einen Schritt der Wärmebehandlung getrennt sind, und
wobei mindestens einer der Schritte der Wärmebehandlung bei Luftdruck bei einer Temperatur zwischen 1100 °C und 1300 °C während einer Dauer von 1 bis 7 Stunden durchgeführt wird.

2. Verfahren zur Aktivierung von Dotierungsmitteln nach Anspruch 1, bei dem die Schutzschicht (2) nach mindestens einer der Wärmebehandlungen abgezogen wird, und dann eine zweite Schutzschicht (2) auf die Schicht aus Halbleitermaterial (1b) vor der folgenden Wärmebehandlung aufgebracht wird.

3. Verfahren zur Aktivierung von Dotierungsmitteln nach den Ansprüchen 1 und 2, bei dem die Dicke der Schutzschicht (2) und/oder der zweiten Schutzschicht (2) zwischen 5 und 500 nm, vorteilhafterweise zwischen 5 und 100 nm und bevorzugt zwischen 5 und 40 nm beträgt.

4. Verfahren zur Aktivierung von Dotierungsmitteln nach den Ansprüchen 1 und 2, bei dem die Schutzschicht (2) und/oder die zweite Schutzschicht (2) für mehrere aufeinanderfolgende Wärmebehandlungen verwendet wird, und bei dem ihre Dicke zwischen 5 und 500 nm, vorteilhafterweise zwischen 5 und 150 nm und bevorzugt zwischen 80 und 120 nm beträgt.

5. Verfahren zur Aktivierung von Dotierungsmitteln nach einem der Ansprüche 1 bis 4, bei dem das Material der Schutzschicht (2) und/oder der zweiten Schutzschicht (2) unter SiO₂, Si₃N₄ oder AlN ausgewählt ist.

6. Verfahren zur Aktivierung von Dotierungsmitteln nach einem der Ansprüche 1 bis 5, bei dem bei jedem Implantierungsschritt eine Zwischendosis von mehr als 10 % der zu implantierenden Gesamtdosis implantiert wird.

7. Verfahren zur Aktivierung von Dotierungsmitteln nach einem der Ansprüche 1 bis 6, bei dem der mindestens eine der Implantierungsschritte bei einer Temperatur zwischen 15 und 700 °C, vorzugsweise gleich 500 °C, durchgeführt wird.

8. Verfahren zur Aktivierung von Dotierungsmitteln nach einem der Ansprüche 1 bis 7, bei dem bei jedem neuen Implantierungsschritt die elektrisch dotierenden Verunreinigungen (3) in einer anderen Tiefe als jener, die bei den vorhergehenden Implantierungsschritten erhalten wird, implantiert werden.

9. Verfahren zur Aktivierung von Dotierungsmitteln nach einem der Ansprüche 1 bis 8, bei dem mindestens einer der Wärmebehandlungsschritte unter kontrollierter Atmosphäre bei einem Druck unter 15 kbar, bei einer Temperatur zwischen 1000 °C und 1600 °C während einer Dauer von 1 bis 20 Minuten durchgeführt wird.

10. Verfahren zur Aktivierung von Dotierungsmitteln nach einem der Ansprüche 1 bis 9, bei dem mindestens einer der Wärmebehandlungsschritte eine Kombination von mindestens zwei Glühungen mit unterschiedlichen Dauern und Temperaturen ist.

11. Verfahren zur Aktivierung von Dotierungsmitteln nach einem der Ansprüche 1 bis 10, bei dem die elektrisch dotierenden Verunreinigungen (3) ausgewählt sind unter Mg, P, N, Ca, Zn oder C, um ein Dotierungsmittel des Typs p zu bilden.

12. Verfahren zur Aktivierung von Dotierungsmitteln nach einem der Ansprüche 1 bis 10, bei dem die elektrisch dotierenden Verunreinigungen (3) ausgewählt sind unter Si, Be, Ge oder O, um ein Dotierungsmittel des Typs n zu bilden.

## Claims

1. A method for performing activation of n-type or p-type dopants in a GaN-base semiconductor layer comprises the following steps:
• providing a substrate (1) comprising a GaN-base semiconductor material layer (1b),
• performing the following successive steps at least twice:
∘ implanting electric dopant impurities (3) in the semiconductor material layer (1b),
∘ performing heat treatment so as to activate the electric dopant impurities (3) in the semiconductor material layer (1b), a cap layer (2) covering the semiconductor material layer (1b) when the heat treatment is performed,
two implantation steps of electric dopant impurities (3) being separated by a heat treatment step and
at least one of the heat treatment steps is performed at atmospheric pressure at a temperature comprised between 1100°C and 1300°C for a period of 1 to 7 hours.

2. The method for performing activation of dopants according to claim 1, wherein the cap layer (2) is removed after at least one of the heat treatments, and a second cap layer (2) is then deposited on the semiconductor material layer (1b) before the next heat treatment.

3. The method for performing activation of dopants according to one of claims 1 and 2, wherein the thickness of the cap layer (2) and/or of the second cap layer (2) is comprised between 5 and 500 nm, advantageously between 5 and 100 nm, and preferentially between 5 and 40 nm.

4. The method for performing activation of dopants according to one of claims 1 and 2, wherein the cap layer (2) and/or the second cap layer (2) is used for several successive heat treatments, and wherein its thickness is comprised between 5 and 500 nm, advantageously between 5 and 150 nm, and preferentially between 80 and 120 nm.

5. The method for performing activation of dopants according to any one of claims 1 to 4, wherein the material of the cap layer (2) and/or of the second cap layer (2) is chosen from SiO₂, Si₃N₄ or AIN.

6. The method for performing activation of dopants according to any one of claims 1 to 5, wherein, at each implantation step, an intermediate dose greater than 10% of the total dose to be implanted is implanted.

7. The method for performing activation of dopants according to any one of claims 1 to 6, wherein at least one of the implantation steps is performed at a temperature comprised between 15 and 700°C, preferentially equal to 500°C.

8. The method for performing activation of dopants according to any one of claims 1 to 7, wherein, at each new implantation step, the electric dopant impurities (3) are implanted at a different depth from that obtained when the previous implantation steps were performed.

9. The method for performing activation of dopants according to any one of claims 1 to 8, wherein at least one of the heat treatment steps is performed in a controlled atmosphere at a pressure of less than 15 kbar, at a temperature comprised between 1000°C and 1600°C for a period of 1 to 20 minutes.

10. The method for performing activation of dopants according to any one of claims 1 to 9, wherein at least one of the heat treatment steps is a combination of at least two anneals of different durations and temperatures.

11. The method for performing activation of dopants according to any one of claims 1 to 10, wherein the electric dopant impurities (3) are chosen from Mg, P, N, Ca, Zn or C to form a p-type doping.

12. The method for performing activation of dopants according to any one of claims 1 to 10, wherein the electric dopant impurities (3) are chosen from Si, Be, Ge, or O to form an n-type doping.
